# EUROPEAN PATENT APPLICATION

(11) **EP 4 597 562 A1**
(43) Date of publication of application: **06.08.2025**
(21) Application number: 24196701.7
(22) Date of filing: 27.08.2024
(51) Int. Cl.: H01L 23/13, H01L 23/367, H01L 23/433, H01L 23/498, H01L 23/538

(54) **SEMICONDUCTOR PACKAGING STRUCTURE, SEMICONDUCTOR COMPONENT AND ELECTRONIC DEVICE**

(30) Priority: 30.01.2024 CN 202410133033
(71) Applicant: Shanghai X-Ring Technology Co., Ltd., Shanghai 201206 (CN)
(72) Inventor: JING, Xiangmeng, Shanghai 201206 (CN); ZHANG, Xiaodong, Shanghai 201206 (CN); XU, Bin, Shanghai 201206 (CN); HUA, Xiuwen, Shanghai 201206 (CN)
(74) Representative: Stöckeler, Ferdinand

(57) **Abstract**

A semiconductor packaging structure includes: a first packaging body (100) and a second packaging body (200). The first packaging body (100) includes a first substrate (110) and a first chip (120), and the first chip (120) is located on the first substrate (110). The second packaging body (200) is coupled to the first packaging body (100) and includes a second substrate (210), the first chip (120) is located between the first substrate (110) and the second substrate (210). A ratio of a thickness T1 of the first chip (120) to a distance D1 between the first substrate (110) and the second substrate (210) is less than 0.5.

## Description

### TECHNICAL FIELD

The present invention generally relates to the field of semiconductor packaging technologies, and more particularly to a semiconductor packaging structure, a semiconductor component and an electronic device.

### BACKGROUND

The package-on-package (PoP) technology is a typical three-dimensional packaging technology. Because PoP technology has structural characteristics of being capable of integrating a logic chip and a memory chip at the same time, it has become one of the main packaging solutions that are constantly evolving to achieve smaller volume and thinner size characteristics.

The PoP technology is used to obtain a packaging structure formed by vertically stacking two or more chips, which can reduce the area occupied by the chips on the main board, and thus have been widely used in mobile phones, tablets and other electronic devices. In pursuit of structural characteristics of smaller volume and thinner size, the overall thickness of the packaging structure is continuously compressed by reducing the thickness of the logic chip in the related art. However, decrease in the thickness of the logic chip will not only reduce the structural strength of the logic chip in the packaging structure and affect the reliability of the packaging structure, but it also causes uneven heating of the chip and affects the operation performance of the packaging structure.

Therefore, how to provide a semiconductor packaging structure, a semiconductor component and an electronic device is a technical problem that has not been solved in the field.

### SUMMARY

The present invention seeks to solve at least one of these problems to at least some extent.

For this purpose, a first objective of the present invention is to provide a semiconductor packaging structure, a semiconductor component and an electronic device, which can meet the performance requirements of the chip in the case of meeting the small volume requirements of the packaging structure.

The present invention is defined by the appended claims.

According to a first aspect of embodiments of the present invention, there is provided a semiconductor packaging structure, including a first packaging body including a first substrate and a first chip located on the first substrate; and a second packaging body coupled to the first packaging body and including a second substrate, the first chip being located between the first substrate and the second substrate; wherein a ratio of a thickness T1 of the first chip to a distance D1 between the first substrate and the second substrate is less than 0.5.

Optionally, the thickness T1 of the first chip is in a range of 50 µm to 90 µm.

Optionally, the semiconductor packaging structure further includes a heat dissipation structure disposed on the first chip.

Optionally, the heat dissipation structure is disposed between the first chip and the second substrate, and is in direct contact with and covers a first upper surface of the first chip, the first upper surface being a surface of the first chip away from the first substrate.

Optionally, a ratio of a thickness T2 of the heat dissipation structure to the distance D1 between the first substrate and the second substrate is in a range of 0.3 to 0.5.

Optionally, the thickness T2 of the heat dissipation structure is in a range of 5 µm to 40 µm.

Optionally, a distance D2 between the heat dissipation structure and the second substrate is not greater than 40 µm.

Optionally, the heat dissipation structure includes one of a diamond material, a silicon material or a copper material.

Optionally, the first packaging body further includes an encapsulation layer filled between the first substrate and the second substrate, and wrapping around and encapsulating the first chip; and a conductive structure located in the encapsulation layer, disposed at a periphery of the first chip, and electrically connecting the first substrate with the second substrate.

Optionally, a first wiring layer is disposed in the first substrate, and electrically connected with a first lower surface of the first chip, the first lower surface being a surface of the first chip near the first substrate; and a second wiring layer is disposed in the second substrate, and electrically connected with the first wiring structure via the conductive structure.

Optionally, the semiconductor packaging structure further includes a heat dissipation structure located on a surface of the second substrate away from the first substrate, wherein a vertical projection of the first chip on the first substrate at least partially overlaps with a vertical projection of the heat dissipation structure on the first substrate in a direction perpendicular to a surface of the first substrate.

Optionally, the semiconductor packaging structure further includes a heat dissipation structure penetrating through the second substrate, and being in contact with and covering a first upper surface of the first chip, wherein a vertical projection of the first chip on the first substrate at least partially overlaps with a vertical projection of the heat dissipation structure on the first substrate in a direction perpendicular to a surface of the first substrate.

Optionally, the semiconductor packaging structure further includes a heat dissipation structure penetrating through the second substrate, and being at a predetermined distance from a first upper surface of the first substrate, wherein a vertical projection of the first chip on the first substrate at least partially overlaps with a vertical projection of the heat dissipation structure on the first substrate in a direction perpendicular to a surface of the first substrate.

Optionally, the semiconductor packaging structure further includes a heat dissipation structure, wherein the second structure includes a groove not penetrating through the second substrate, and the heat dissipation structure is filled in the groove, wherein a vertical projection of the first chip on the first substrate at least partially overlaps with a vertical projection of the heat dissipation structure on the first substrate in a direction perpendicular to a surface of the first substrate.

According to a second aspect of embodiments of the present invention, there is provided a semiconductor component including the semiconductor packaging structure in any one of the above embodiments.

According to a third aspect of embodiments of the present invention, there is provided an electronic device including the semiconductor packaging structure in any one of the above embodiments.

The semiconductor packaging structure, the semiconductor component and the electronic device according to embodiments of the present invention at least have the following beneficial effects.

The present invention provides a semiconductor packaging structure, a semiconductor component and an electronic device. The semiconductor packaging structure includes a first packaging body and a second packaging body. The first packaging body includes a first substrate, and a first chip located on the first substrate. The second packaging body includes a second substrate located on the first chip. By controlling the ratio of the thickness of the first chip to the distance between the first substrate and the second substrate to be not greater than 0.5, it is possible to maintain the structure and performance stability of the first chip while simultaneously decreasing the volume of the semiconductor packaging structure and the thickness of the first chip, so as to satisfy the requirements of a small volume and high reliability of the semiconductor packaging structure.

Further, the present invention provides a semiconductor packaging structure, a semiconductor component and an electronic device. The semiconductor packaging structure further includes a heat dissipation structure disposed on the first chip. By disposing the heat dissipation structure with a high thermal conductivity on the first chip, the heat radiated by the first chip as a heat source can be quickly dissipated out under the guidance of the heat dissipation structure, such that the heat dissipation efficiency of the first chip is improved, the temperature of the first chip is prevented from exceeding a temperature threshold range, and the heat dissipation efficiency of the first chip is not limited by the thickness of the first chip, thereby serving the purpose of further reducing the thickness of the first chip and the volume of the semiconductor packaging structure.

Additional aspects and advantages of the present invention will be given in part in the following descriptions, become apparent in part from the following descriptions, or be learned from the practice of the present invention.

### BRIEF DESCRIPTION OF THE DRAWINGS

These and/or other aspects and advantages of the present invention will become apparent and more readily appreciated from the following descriptions made with reference to the drawings, in which:

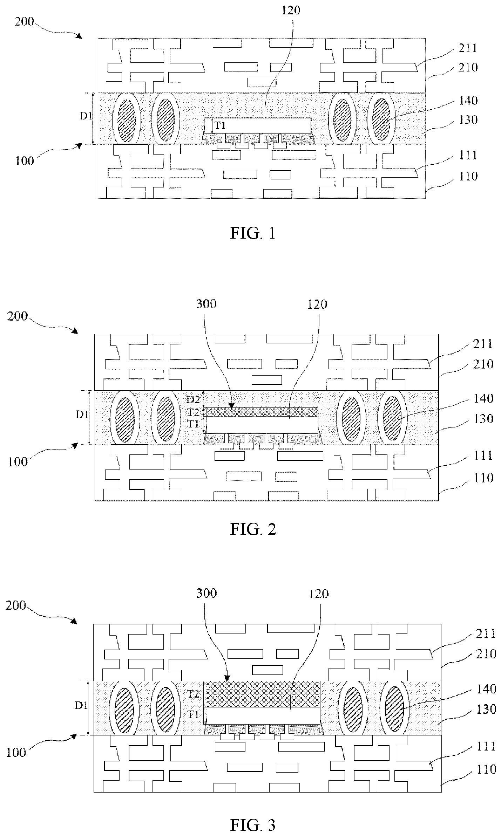

FIGS. 1-10 are schematic sectional diagrams illustrating a semiconductor packaging structure according to an illustrative embodiment of the present invention.

### DETAILED DESCRIPTION

Reference will be made in detail to embodiments of the present invention, examples of which are shown in the drawings. The same or similar elements or the elements having the same or similar functions are denoted by the same or similar reference numerals throughout the descriptions. The embodiments described herein with reference to drawings are illustrative, and used to explain the present invention. The embodiments shall not be construed to limit the present invention.

At present, in order to further pursue the structural characteristics of smaller volume and thinner size of electronic devices, the total volume of the internal packaging structure is usually continuously compressed, especially the thickness of the packaging structure, which, in turn, is related to the thickness of the internal chip. Thus, reducing the thickness of the chip becomes a major approach to achieving the goal of smaller volume and thinner size of electronic devices. However, reduction in the thickness of the chip leads to reduction in the overall structural strength of the chip and affects the structural stability of the chip inside the packaging structure. At the same time, the further reduction in the thickness of the chip will also affect the heat dissipation efficiency of the chip, so that the chip inside the packaging structure will have a large temperature gradient due to uneven heat dissipation. When the temperature gradient is serious, it will also reduce the operation performance of the chip and affect the performance stability of the chip inside the packaging structure.

Therefore, there is a technical problem on how to adjust the size of the packaging structure and the size of the chips inside the packaging structure reasonably within the existing process capabilities, so as to meet the structural requirements of smaller volume and thinner size of the packaging structure, without affecting the reliability and performance stability of the packaging structure.

Based on the above problem, a first aspect of embodiments of the present invention provides a semiconductor packaging structure. As shown in FIG. 1, the semiconductor packaging structure includes a first packaging body 100, and a second packaging body 200 coupled to the first packaging body 100. The first packaging body 100 includes a first substrate 110, and a first chip 120 located on the first substrate 110. The second packaging body 200 includes a second substrate 210. The first chip 120 is located between the first substrate 110 and the second substrate 210. A ratio of a thickness T1 of the first chip 120 to a distance D1 between the first substrate 110 and the second substrate 210 is less than 0.5.

Chips are obtained by cutting wafers, and to maintain a certain degree of operability, the thickness of wafers produced by foundries is generally around 700 µm. Then, the packaging and testing factory must grind and thin the wafers before they are suitable for cutting and assembly. Generally, wafers need to be ground to a preset thickness, especially for chips used in stacked/layered structures. The wafers used in stacked/layered structures generally need to be ground to a thickness below the preset thickness. For example, the thickness of the chips in stacked/layered structures/packages is usually around 100 µm, so as to minimize the size of the semiconductor packaging structure as much as possible under conventional packaging processes. However, the larger the thickness of the chips, the more vastly the heat dissipation efficiency of the chips is improved, thereby obtaining a stronger power budget. That is, a certain proportional relationship between the thickness of the chips and the size of the semiconductor packaging structure needs to be met, so as to balance the structural characteristics of small size and strong power budget of the semiconductor packaging structure.

Since the first chip 120 is located between the first substrate 110 and the second substrate 210, and the ratio of the thickness T1 of the first chip 120 to the distance D1 between the first substrate 110 and the second substrate 210 is not greater than 0.5, a substantially positive correlation relationship is present between the thickness T1 of the first chip 120 and the distance D1 between the first substrate 110 and the second substrate 210. That is, the range of the distance D1 between the first substrate 110 and the second substrate 210 can be primarily calculated by controlling the thickness T 1 of the first chip 120, such that the volume of the first packaging body 100 can be controlled within a desirable dimension range so as to control the overall volume of the semiconductor packaging structure.

Therefore, when the ratio of the thickness T 1 of the first chip 120 to the distance D1 between the first substrate 110 and the second substrate 210 is not greater than 0.5, during or after the process of packaging the first chip 120 to form the first packaging body 100, the packaging stress to which the first chip 120 is subjected will be within a preset stress threshold range, avoiding structural problems such as breakage or warping of the first chip 120 inside the first packaging body 100, thereby ensuring the structural stability of the first chip 120 inside the first packaging body 100.

Meanwhile, since the ratio of the thickness T1 of the first chip 120 to the distance D1 between the first substrate 110 and the second substrate 210 is less than 0.5, not only can the volume of the semiconductor packaging structure be decreased simultaneously with the thickness of the first chip 120, but also the balance between the heat dissipation efficiency of the first chip 120 during the operation and the heat dissipation efficiency of the first packaging body 100 is maintained, such that the temperature of the first chip 120 is maintained within a preset temperature threshold range, thereby ensuring the performance stability of the first chip 120 inside the first packaging body 100 and maintaining the strong power budget of the semiconductor packaging structure.

As an example, the ratio of the thickness T1 of the first chip 120 to the distance D1 between the first substrate 110 and the second substrate 210 is in a range of 0.2 to 0.49, so as to reduce the thickness T1 of the first chip 120 and the thickness of the first packaging body 100, thus decreasing the volume of the semiconductor packaging structure.

As an example, the thickness T1 of the first chip 120 is in a range of 50 µm to 90 µm, which can be in a range of 50 µm to 70 µm or in a range of 70 µm to 90 µm, so as to control the thickness T1 of the first chip 120 to be below 100 µm.

Additionally, the first chip 120 can be a flip chip, and has a first upper surface and a first lower surface opposite to each other. The first upper surface of the first chip 120 is a surface of the first chip 120 near the second substrate 210, and the first lower surface of the first chip 120 is a surface of the first chip 120 near the first substrate 110. Thus, the first chip 120 can be coupled to the first substrate 110 through multiple solder joints. The solder joints can be solder balls, solder pillars, copper pillars, etc.

The first chip 120 includes a system-on-chip (SoC), a logic device, a memory device, a radio frequency (RF) device, or any combination thereof. For example, the first chip 120 may include a micro control unit (MCU) bare chip, a micro processor unit (MPU) chip, a power management integrated circuit (PMIC) chip, a radio frequency front end (RFFE) chip, an accelerated processing unit (APU) chip, a central processing unit (CPU) chip, a graphics processing unit (GPU) chip, an input output (IO) chip, a dynamic random access memory (DRAM) controller, a static random access memory (SRAM), a high bandwidth memory (HBM), an application processor (AP) chip, or any combination thereof.

It is to be noted that the above semiconductor packaging structure is applicable to a PoP structure, including, but not limited to, being applied to any suitable electronic device. For example, the electronic device includes smartphones, tablets, laptops, wearable electronic devices such as smart watches, set-top boxes such as media devices or mobile hotspots, and automotive computing systems such as navigation and entertainment systems.

As shown in FIG. 1, in some embodiments, the first packaging body 100 further includes an encapsulation layer 130, and a conductive structure 140 located in the encapsulation layer 130. The encapsulation layer 130 is filled between the first substrate 110 and the second substrate 210, and wraps around and encapsulates the first chip 120. The conductive structure 140 is disposed at a periphery of the first chip 120, and electrically connects the first substrate 110 with the second substrate 210.

It is understandable that, since the encapsulation layer 130 wraps around and encapsulates the first chip 120, and separates the first chip 120 from the second packaging body 200, the first chip 120 can be stably disposed on the first substrate 110, such that the first chip 120 can be protected from the surrounding environment, and thus prevented from being damaged by uncertain factors such as internal and external stress, chemicals, and/or moisture, thus ensuring the stability of the structure and/or performance of the first chip 120 inside the first packaging body 100.

Meanwhile, due to the low thermal conductivity (0.024 watts per meter Kelvin, W/mK) of air that suppresses the diffusion of heat radiation, it is difficult for the heat generated by the first chip 120 as a heat source to be quickly dissipated through air. Therefore, during the operation, the first chip 120 needs a medium with a high thermal conductivity at its periphery to quickly dissipate the heat on a surface of the first chip 120, so as to prevent the temperature of the first chip 120 from exceeding the temperature threshold range and affecting the performance stability of the first chip 120. By disposing the encapsulation layer 130 between the first substrate 110 and the second substrate 210, not only can bottom support be provided for the second substrate 210 to be located above the first chip 120, but also it is possible to transfer the heat generated by the first chip 120 during the operation to the second substrate 210 to a certain extent, and dissipate the heat from the second substrate 210 to the outside of the semiconductor packaging structure, so that the surface temperature of the first chip 120 can be maintained within the temperature threshold range, thus effectively improving the heat conduction efficiency of the first chip 120 and ensuring the performance stability of the first chip 120.

Further, since the conductive structure 140 electrically connects the first substrate 110 with the second substrate 210, the first chip 120 on the first substrate 110 can be electrically connected with the second chip 220 on the second substrate 210 via the conductive structure 140. That is, the second packaging body 200 is coupled to the conductive structure 140, such that the first packaging body 100 can be electrically connected with the second packaging body 200.

Since the conductive structure 140 is disposed around the periphery of the first chip 120, the first chip 120 is wrapped by the encapsulation layer 130, and the conductive structure 140 is spaced apart from a side of the first chip 120, the conductive structure 140 can also be protected from environmental influences by the encapsulation layer 130, and thus prevented from being damaged by uncertain factors such as internal and external stress, chemicals, and/or moisture, thus ensuring the stability of the internal structure and/or performance of the semiconductor packaging structure.

It is to be noted that the encapsulation layer 130 is made of a non-conductive material, including, but not limited to, a moldable polymer, an epoxy resin, a resin, or a combination thereof.

The conductive structure 140 is made of a conductive material, including conductive pillars, solder balls, copper core solder balls, or combinations thereof, including, but not limited to, copper, aluminum, tungsten and other metals, or alloys or combinations thereof.

As shown in FIG. 1, in some embodiments, a first wiring layer 111 is disposed in the first substrate 110 and electrically connected with the first lower surface of the first chip 120, and a second wiring layer 211 is disposed in the second substrate 210 and electrically connected with the first wiring structure 111 via the conductive structure 140.

It is understandable that main bodies of the first substrate 110 and the second substrate 210 can be passivation layers formed from dielectric materials and/or polymer materials, the first wiring structure 111 and the second wiring layer 211 are disposed in the passivation layers, respectively, and only partial surfaces of the first wiring structure 111 and the second wiring layer 211 are exposed at preset positions, such that the conductive structure 140 can electrically connect the first wiring structure 111 with the second wiring layer 211 via the partial surfaces.

Similarly, the first chip 120 is located on the first substrate 110, and coupled to partially exposed surfaces of the first wiring structure 111 via multiple solder joints, such that the first chip 120 can be electrically connected with the second wiring layer 211.

As an example, the polymer materials include polyimides (PIs), polybenzoxazoles (PBOs), benzocyclobutenes (BCBs), epoxy resins, or combinations thereof; and the dielectric materials include silicon oxide, silicon carbide, silicon nitride, silicon oxynitride, or combinations thereof.

The first wiring structure 111 and the second wiring layer 211 can include conductive layers, conductive pillars, conductive vias, or combinations thereof. The first wiring structure 111 and the second wiring layer 211 can be formed from conductive metal materials, including copper, gold, tungsten and other metal elements, or metal alloys or combinations thereof.

As shown in FIGS. 2-9, in some embodiments, the semiconductor packaging structure further includes a heat dissipation structure 300 disposed on the first chip 120.

It is understandable that the heat dissipation structure 300 can be formed from metal and/or non-metallic materials with a high thermal conductivity. By disposing the heat dissipation structure 300 with a high thermal conductivity on the first chip 120, the heat radiated by the first chip 120 as a heat source can be quickly dissipated out under the guidance of the heat dissipation structure 300, such that the heat dissipation efficiency of the first chip 120 is improved, the temperature of the first chip 120 is prevented from exceeding the temperature threshold range, and the heat dissipation efficiency of the first chip 120 is not limited by the thickness of the first chip 120, thereby serving the purpose of further reducing the thickness of the first chip 120 and the volume of the semiconductor packaging structure.

As an example, the heat dissipation structure 300 includes a diamond material, a silicon material, a copper material, or a combination thereof.

As shown in FIGS. 2-4, in some embodiments, the heat dissipation structure 300 is disposed between the first chip 120 and the second substrate 210, and is in direct contact with and covers the first upper surface of the first chip 120.

It is understandable that, since the heat dissipation structure 300 is in direct contact with and covers the first upper surface of the first chip 120, the heat dissipation structure 300 can be a first upper surface attachment film attached onto the first chip 120, so as to be in direct contact with the first chip 120, thus quickly dissipating the heat radiated by the first chip 120. Meanwhile, the attachment of the heat dissipation structure 300 onto the first chip 120 also can further reduce the thickness of the first chip 120, thus further reducing the size of the first packaging body 100.

As an example, when the heat dissipation structure 300 is formed from a diamond material, its thermal conductivity can reach 900 W/mK to 2320 W/mK, which is much greater than the thermal conductivity of the silicon material forming the first chip 120 and the material forming the encapsulation layer 130 wrapping around the first chip 120. That is, by attaching the heat dissipation structure 300 onto the first upper surface of the first chip 120, the internal heat of the first chip 120 can be quickly dissipated from the first upper surface of the first chip 120, while also making the temperature of the first upper surface of the first chip 120 more uniform and preventing a large temperature gradient from occurring on the first upper surface of the first chip 120.

Further, when a ratio of a thickness T2 of the heat dissipation structure 300 to the distance D1 between the first substrate 110 and the second substrate 210 is in a range of 0.3 to 0.5, the heat dissipation structure 300 not only can further reduce the thickness T1 of the first chip 120, but also can effectively control the temperature of the first chip 120, such that the temperature of the first chip 120 is maintained within the temperature threshold range, thereby ensuring the performance stability of the first chip 120 inside the first packaging body 100 and maintaining the strong power budget while also further improving the size of the first packaging body 100. Additionally, as the thickness T1 of the first chip 120 further decreases, the stress on the first chip 120 can also be further reduced, thus improving the yield of the packaging structure.

When the ratio of the thickness T2 of the heat dissipation structure 300 to the distance D1 between the first substrate 110 and the second substrate 210 is in a range of 0.3 to 0.44, and the ratio of the thickness T1 of the first chip 120 to the distance D1 between the first substrate 110 and the second substrate 210 is in a range of 0.35 to 0.49, the heat dissipation of the first chip 210 and the packaging stress on the first chip 210 can also reach a relatively low equilibrium state.

The thickness T2 of the heat dissipation structure 300 is in a range of 5 µm to 40 µm. A distance D2 between the heat dissipation structure 300 and the second substrate 210 is not greater than 40 µm. The larger the thickness T2 of the heat dissipation structure 300, the smaller the range of the distance D2 between the heat dissipation structure 300 and the second substrate 210, and the higher the heat dissipation efficiency of the heat dissipation structure 300 for the first chip 120.

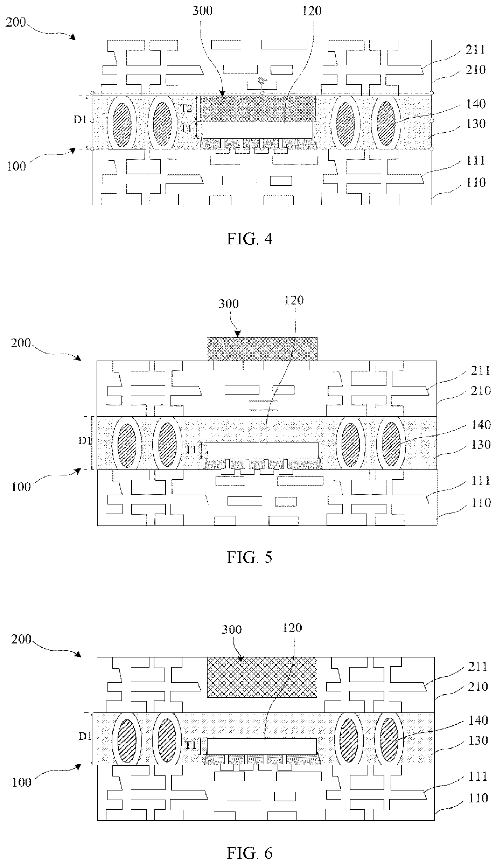

As shown in FIGS. 3 and 4, when the distance D2 between the heat dissipation structure 300 and the second substrate 210 tends towards 0 µm, the upper surface of the heat dissipation structure 300 is substantially coplanar with the upper surface of the encapsulation layer 130, forming the upper surface of the first packaging body 100. The second substrate 210 is coupled to the first packaging body 100, such that the heat dissipation structure 300 is in direct contact with the lower surface of the second substrate 210. Therefore, the heat dissipation structure 300 can directly transfer the heat generated by the first chip 120 to the second substrate 210, and the heat is transferred to the outside of the semiconductor packaging structure through the second wiring layer 211 disposed inside the second substrate 210. Thus, the first chip 120 is continuously within the temperature threshold range, thus ensuring the performance stability of the first chip 120 inside the first packaging body 100.

It is to be noted that the coverage area of the heat dissipation structure 300 on the first upper surface of the first chip 120 is not specifically limited in the present invention. The coverage area of the heat dissipation structure 300 on the first upper surface of the first chip 120 can be greater than, equal to, or smaller than the area of the first upper surface of the first chip 120. As shown in FIG. 4, the larger the coverage area of the heat dissipation structure 300 on the first upper surface of the first chip 120, the higher the heat dissipation efficiency of the heat dissipation structure 300 for the first chip 120, and the stronger the control over the uniformity of the internal temperature of the first chip 120, thus reducing the internal temperature gradient of the first chip 120 during the operation.

As shown in FIGS. 5 to 9, in other embodiments, the heat dissipation structure 300 is disposed on the first chip 120, but not limited to, between the first chip 120 and the second substrate 210, and in a direction perpendicular to the surface of the first substrate 110, the vertical projection of the first chip 120 on the first substrate 110 at least partially overlaps with the vertical projection of the heat dissipation structure 300 on the first substrate 110.

As shown in FIG. 5, when the heat dissipation structure 300 is directly disposed on a surface of the second substrate 210 close to the first substrate 110, the heat radiated by the first chip 120 as a heat source can be quickly dissipated under the guidance of the heat dissipation structure 300, thereby improving the heat dissipation efficiency of the first chip 120, preventing the temperature of the first chip 120 from exceeding the temperature threshold range, and improving the performance or reliability of the first chip 120.

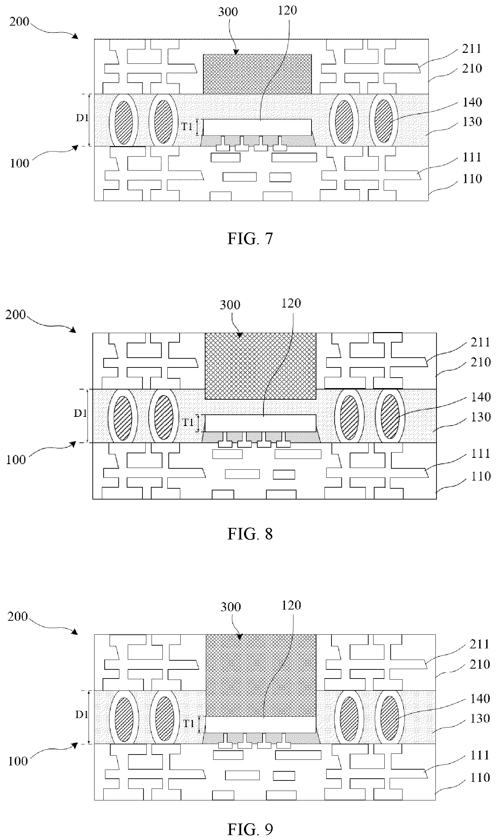

Furthermore, as shown in FIGS. 6 and 7, the heat dissipation structure 300 is disposed inside the second substrate 210, and filled in a groove at a surface of the second substrate 210 away from the first substrate 110 or a groove at a surface of the second substrate 210 near the first substrate 110 to reduce the distance between the heat dissipation structure 300 and the first chip 120, thereby shortening the heat dissipation path of the first chip 120 and improving the heat dissipation efficiency of the first chip 120. The groove does not penetrate through the second substrate 210.

Furthermore, as shown in FIG. 8, the heat dissipation structure 300 is disposed inside the second substrate 210, extends vertically from the surface of the second substrate 210 away from the first substrate 110, penetrates through the second substrate 210 and is at a predetermined distance from the first upper surface of the first substrate 110, so as to further reduce the distance between the heat dissipation structure 300 and the first chip 120 and shorten the heat dissipation path of the first chip 120.

Furthermore, as shown in FIG. 9, the heat dissipation structure 300 is disposed inside the second substrate 210, extends vertically from the surface of the second substrate 210 away from the first substrate 110, penetrates through the second substrate 210, is in contact with the first upper surface of the first chip 120, and extends to cover the first upper surface of the first chip 120, so as to further reduce the distance between the heat dissipation structure 300 and the first chip 120 and shorten the heat dissipation path of the first chip 120.

Meanwhile, since the vertical projection of the first chip 120 on the first substrate 110 at least partially overlaps with the vertical projection of the heat dissipation structure 300 on the first substrate 110, the larger the vertically overlapped area, the larger the reduction in the straight-line distance between the heat dissipation structure 300 and the first chip 120, and the higher the heat dissipation efficiency of the heat dissipation structure 300 for the first chip 120.

It is to be noted that the specific structural form of the heat dissipation structure 300 on the second substrate 210 is not specifically limited in the present invention. The smaller the distance between the heat dissipation structure 300 and the first chip 120, and the larger the overlap area between the vertical projection of the first chip 120 on the first substrate 110 and the vertical projection of the heat dissipation structure 300 on the first substrate 110, the shorter the heat dissipation path of the first chip 120, and the larger the increase in the heat dissipation efficiency of the first chip 120, thus improving the performance or reliability of the first chip 120.

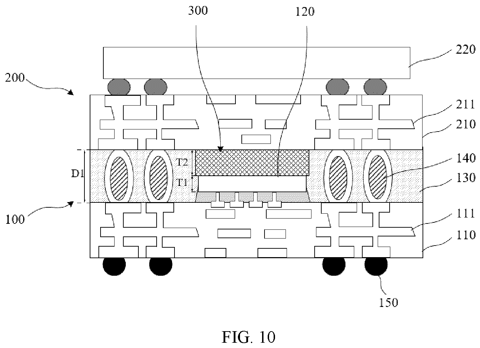

As shown in FIG. 10, in some embodiments, the second packaging body 200 further includes a second chip 220 located on the second substrate 210.

It is understandable that the second chip 220 can be a flip chip, and has a second upper surface and a second lower surface opposite to each other. The second lower surface of the second chip 220 is a surface of the second chip 220 near the second substrate 210, and the second upper surface of the second chip 220 is a surface of the second chip 220 away from the second substrate 210.

The second chip 220 is coupled to the second substrate 210 through multiple solder joints, and is electrically connected with the second wiring layer 211 that is disposed inside the second substrate 210 and has partially exposed surfaces, so that the second chip 220 can be electrically connected with the first chip 120 through the second wiring layer 211, a connection structure, and the first wiring layer 111 in sequence. The solder joints connecting the second chip 220 with the second wiring layer 211 can be solder balls, solder pillars, copper pillars, etc.

The second chip 220 includes a system-on-chip (SoC), a logic device, a memory device, a radio frequency (RF) device, or any combination thereof. For example, the second chip 220 may include a micro control unit (MCU) bare chip, a micro processor unit (MPU) chip, a power management integrated circuit (PMIC) chip, a radio frequency front end (RFFE) chip, an accelerated processing unit (APU) chip, a central processing unit (CPU) chip, a graphics processing unit (GPU) chip, an input output (IO) chip, a dynamic random access memory (DRAM) controller, a static random access memory (SRAM), a high bandwidth memory (HBM), an application processor (AP) chip, or any combination thereof.

As shown in FIG. 10, in some embodiments, the first packaging body 100 further includes multiple conductive terminals 150 disposed below the first substrate 110.

It is understandable that, by disposing multiple conductive terminals 150 below the first substrate 110, the semiconductor packaging structure can be coupled and connected to a printed circuit board (PCB) through the conductive terminals 150 in subsequent processes, thereby enabling the electrical connection of the semiconductor packaging structure with the outside through the printed circuit board.

Due to the arrangement of the first wiring layer 111 inside the first substrate 110 and the partial exposure of the surface of the first wiring layer 111 at a predetermined position, an electrical connection between the conductive terminals 150 and the first wiring layer 111 can be formed by coupling the conductive terminals 150 with the partially exposed surface of the first wiring layer 111.

It is to be noted that the type of the conductive terminals 150 includes micro bumps, solder balls, ball grids, or combinations thereof. The specific materials of the conductive terminals 150 can be formed from conductive materials, including, but not limited to, metals such as copper, aluminum, or tungsten, or alloys or combinations of metals and alloys thereof.

The second aspect of embodiments of the present invention also provides a semiconductor component including the semiconductor packaging structure described in any one of the above embodiments.

The third aspect of embodiments of the present invention also provides an electronic device including the semiconductor packaging structure described in any one of the above embodiments.

In summary, the present invention provides a semiconductor packaging structure, a semiconductor component, and an electronic device, wherein the semiconductor component and the electronic device each include the semiconductor packaging structure. The semiconductor packaging structure includes a first packaging body 100 and a second packaging body 200. The first packaging body 100 includes a first substrate 110 and a first chip 120, and the second packaging body 200 includes a second substrate 210. The first chip 120 is located on the first substrate 110, and the second substrate 210 is located on the first chip 120. By controlling the ratio of the thickness of the first chip 120 to the distance between the first substrate 110 and the second substrate 210 to be not greater than 0.5, it is possible to maintain the structure and performance stability of the first chip 120 while simultaneously decreasing the volume of the semiconductor packaging structure and the thickness of the first chip 120, so as to satisfy the requirements of a small volume and high reliability of the semiconductor packaging structure.

Further, the present invention provides a semiconductor packaging structure, a semiconductor component and an electronic device. The semiconductor packaging structure further includes a heat dissipation structure 300 disposed on the first chip 120. By disposing the heat dissipation structure 300 with a high thermal conductivity on the first chip 120, the heat radiated by the first chip 120 as a heat source can be quickly dissipated out under the guidance of the heat dissipation structure 300, such that the heat dissipation efficiency of the first chip 120 is improved, the temperature of the first chip 120 is prevented from exceeding a temperature threshold range, and the heat dissipation efficiency of the first chip 120 is not limited by the thickness of the first chip 120, thereby serving the purpose of further reducing the thickness of the first chip 120 and the volume of the semiconductor packaging structure.

Reference throughout this specification to terms "an embodiment," "some embodiments," "an example," "a specific example," or "some examples", etc., means that a particular feature, structure, material, or characteristic described in connection with the embodiment or example is included in at least one embodiment or example of the present invention. Schematic expressions of the above terms throughout this specification are not necessarily referring to the same embodiment or example. Furthermore, the particular features, structures, materials, or characteristics described may be combined in any suitable manner in one or more embodiments or examples. In addition, those skilled in the art can combine the different embodiments or examples and the features of the different embodiments or examples described in this specification without being mutually inconsistent.

In addition, terms such as "first" and "second" are used herein for purposes of description and are not intended to indicate or imply relative importance or significance or to imply the number of indicated technical features. Thus, the feature defined with "first" and "second" may comprise one or more of this feature explicitly or implicitly. In the description of the present invention, "a plurality of" means at least two, e.g., two, three, etc. unless specified otherwise.

## Claims

1. A semiconductor packaging structure comprising:
a first packaging body (100) comprising a first substrate (110) and a first chip (120), the first chip (120) located on the first substrate (110); and
a second packaging body (200) coupled to the first packaging body (100), the second packaging body (200) comprising a second substrate (210), the first chip (120) being located between the first substrate (110) and the second substrate (210);
wherein a ratio of a thickness, T1, of the first chip (120) to a distance (D1) between the first substrate (110) and the second substrate (210) is less than 0.5.

2. The semiconductor packaging structure of claim 1, wherein T1 is in a range of 50 µm to 90 µm.

3. The semiconductor packaging structure of claim 1 or 2, further comprising:
a heat dissipation structure (300) disposed on the first chip (120).

4. The semiconductor packaging structure of claim 3, wherein the heat dissipation structure (300) is disposed between the first chip (120) and the second substrate (210), and wherein the heat dissipation structure (300) is in direct contact with and covers a first upper surface of the first chip (120), the first upper surface being a surface of the first chip (120) away from the first substrate (110).

5. The semiconductor packaging structure of claim 4, wherein a ratio of a thickness, T2, of the heat dissipation structure (300) to the distance (D1) between the first substrate (110) and the second substrate (210) is in a range of 0.3 to 0.5, preferably T2 is in a range of 5 µm to 40 µm.

6. The semiconductor packaging structure of claim 4 or 5, wherein a distance D2 between the heat dissipation structure (300) and the second substrate (210) is not greater than 40 µm.

7. The semiconductor packaging structure of any one of claims 3 to 6, wherein the heat dissipation structure (300) comprises one of a diamond material, a silicon material or a copper material.

8. The semiconductor packaging structure of any one of claims 1 to 7, wherein the first packaging body (100) further comprises:
an encapsulation layer (130) filled between the first substrate (110) and the second substrate (210), and wrapping around and encapsulating the first chip (120); and
a conductive structure (140) located in the encapsulation layer (130), disposed at a periphery of the first chip (120), and electrically connecting the first substrate (110) with the second substrate (210).

9. The semiconductor packaging structure of claim 8, further comprising:
a first wiring layer (111), disposed in the first substrate (110), and electrically connected with a first lower surface of the first chip (120), the first lower surface being a surface of the first chip (120) near the first substrate (110); and
a second wiring layer (211), disposed in the second substrate (210), and electrically connected with the first wiring structure via the conductive structure (140).

10. The semiconductor packaging structure of claim 3, further comprising:
a heat dissipation structure (300) located on a surface of the second substrate (210) away from the first substrate (110),
wherein a vertical projection of the first chip (120) on the first substrate (110) at least partially overlaps with a vertical projection of the heat dissipation structure (300) on the first substrate (110) in a direction perpendicular to a surface of the first substrate (110).

11. The semiconductor packaging structure of any one of claims 3 to 9, further comprising:
a heat dissipation structure (300) penetrating through the second substrate (210), wherein the heat dissipation structure (300) is in contact with and covering a first upper surface of the first chip (120),
wherein a vertical projection of the first chip (120) on the first substrate (110) at least partially overlaps with a vertical projection of the heat dissipation structure (300) on the first substrate (110) in a direction perpendicular to a surface of the first substrate (110).

12. The semiconductor packaging structure of any one of claims 3 to 9, further comprising:
a heat dissipation structure (300) penetrating through the second substrate (210), wherein the heat dissipation structure (300) is at a predetermined distance from a first upper surface of the first substrate (110),
wherein a vertical projection of the first chip (120) on the first substrate (110) at least partially overlaps with a vertical projection of the heat dissipation structure (300) on the first substrate (110) in a direction perpendicular to a surface of the first substrate (110).

13. The semiconductor packaging structure of claim 3, further comprising:
a heat dissipation structure (300),
wherein the second structure comprises a groove not penetrating through the second substrate (210), and the heat dissipation structure (300) is filled in the groove,
wherein a vertical projection of the first chip (120) on the first substrate (110) at least partially overlaps with a vertical projection of the heat dissipation structure (300) on the first substrate (110) in a direction perpendicular to a surface of the first substrate (110).

14. A semiconductor component comprising the semiconductor packaging structure of any one of claims 1 to 13.

15. An electronic device comprising the semiconductor packaging structure of any one of claims 1 to 13.
